# EUROPEAN PATENT SPECIFICATION

(11) **EP 2 763 162 B1**
(45) Date of publication and mention of the grant of the patent: **11.05.2016**
(21) Application number: 14165494.7
(22) Date of filing: 31.05.2007
(51) Int. Cl.: H01L 21/687, C23C 14/06, C23C 16/26

(54) **Preventing metal contamination of a component in semi-conductors**
VERFAHREN ZUR VERHINDERUNG VON METALLVERUNREINUNGEN DURCH EINEN SUBSTRATHALTER
PROCÉDÉ POUR PRÉVENIR DE CONTAMINATION METALLIQUE PAR UN SUPPORT DE SUBSTRAT

(30) Priority: 02.06.2006 EP 06114915
(43) Date of publication of application: 06.08.2014
(62) Divisional of application: 07729748.9
(73) Proprietor: Sulzer Metaplas GmbH, 51427 Bergisch-Gladbach (DE)
(72) Inventor: Groenen, Roland, 8780 Oostrozebeke (BE); Dekempeneer, Erik, 2390 Oostmalle (BE); Ackerman, Cyndi L., Depew, 14043 (US); Venkatraman, Chandra, Williamsville, 14221 (US); Kirk, Matthew, Lockport, NY 14094 (US)
(74) Representative: Intellectual Property Services GmbH

(56) References cited:
- WO-A-01/90016
- WO-A2-02/01611
- WO-A2-2005/083752
- US-A- 5 812 362
- CHEAH L K ET AL: "Properties of nitrogen doped tetrahedral amorphous carbon films prepared by filtered cathodic vacuum arc technique", JOURNAL OF NON-CRYSTALLINE SOLIDS, NORTH-HOLLAND PUBLISHING COMPANY, AMSTERDAM, NL, vol. 242, no. 1, 1 December 1998 (1998-12-01), pages 40-48, XP004175439, ISSN: 0022-3093
- ROBERTSON J ET AL: "Nitrogen doping of tetrahedral amorphous carbon", DIAMOND AND RELATED MATERIALS, ELSEVIER SCIENCE PUBLISHERS, AMSTERDAM, NL, vol. 4, no. 4, 15 April 1995 (1995-04-15), pages 441-444, XP004066734, ISSN: 0925-9635
- KINOSHITA HARUHISA ET AL: "Physical properties of nitrogen-doped diamond-like amorphous carbon films deposited by supermagnetron plasma chemical vapor deposition", JOURNAL OF VACUUM SCIENCE AND TECHNOLOGY A. VACUUM, SURFACES AND FILMS, AMERICAN INSTITUTE OF PHYSICS, NEW YORK, NY, US, vol. 20, no. 4, July 2002 (2002-07), pages 1481-1485, XP012006152, ISSN: 0734-2101

## Description

### Field of the invention.

The invention relates to a method to provide a substrate with a conductive, metal free, hydrophilic carbon based coating and to a substrate provided with such a coating.

### Background of the invention.

Carbon based coatings such as diamond-like carbon coatings or diamond-like nanocomposite coatings are known in the art.

Respective prior art can be found for example in WO 01/90016 A,

WO 2005/083752 A2, US - A - 5 812 362, Cheah L K et al. (Journal of non-crystalline solids, North-Holland publishing company, Amsterdam, NI, vol. 242, no. 1, 1 December 1998 (1998 12-01), pages 40 - 48, or Robertson J et al. (Diamond and related materials, Elsevier Science Publishers, Amsterdam, NI, vol. 4, no. 4, 15 April 1995 (1995-04-15), pages 441-4444).

For many applications carbon based coatings need to be conductive. It is generally known to dope a carbon based coating with a metal such as a transition metal to influence the electrical conductivity of the coating.

Examples of components coated with carbon based coatings are for example components to transport and/or support semiconductor substrates such as electrostatic chucks, wafer carriers, lift pins and heaters.

In some microchip manufacturing processes, these components require an electrically conductive coating and therefore the carbon based coating is generally doped with a metal such as a transition metal. Preferred doping elements known in the art of carbon based coatings are Fe, Cr, Ni, Co, Ti, W, Zn, Cu, Mn, Al, Na, Ca and K.

However, especially for semiconductor applications, possible metal contamination is a big concern as metal contamination on a semiconductor substrate may degrade the electrical properties of a semiconductor substrate. As features and linewidths on microprocessors are getting smaller and smaller, the risk of metal contamination is becoming higher.

The presence of metallic parts or metal dopants in the system that might come in contact with the wafer can be sufficient to cause metal contamination.

Even the simple phenomenon of sliding a wafer on a metallic surface and/or on a metal containing surface is enough to contaminate the wafer. Elements such as Na, K and Cu are completely unacceptable currently. Other elements such as Al and Ti are tolerated for the current generation of semiconductor processes.

However, processes which will be used for 45 nm nodes or lower nodes will not tolerate any kind of metal contamination.

Therefore, it is desirable to prevent any possible contamination.

To avoid microcontamination surfaces have to be cleaned regularly. Generally, the cleaning is done with organic solvents. However as there is an increasing concern about the use of volatile organic compounds (VOCs) one is looking for alternative cleaning process. Consequently, there is a high interest in cleaning processes using non volatile components.

Since diamond like carbon coatings are generally hydrophobic, wettability is an issue for these applications.

### Summary of the invention.

It is an object of the present invention to avoid the problems of the prior art.

It is a first object of the present invention to provide a method according to independent claim 1 to increase the wettability of a component so that this component can be cleaned with deionized water according to the cleaning method of independent claim 7.

It is a further object of the present invention to provide a substrate according to independent claim 4 with a wear resistant, hard, low friction, thermal stable, conductive, metal free conductive carbon based coating.

According to a first aspect of the present invention, a method to increase the wettability of a substrate is provided.

The method comprises providing the substrate at least partially with a conductive, metal free, hydrophilic carbon based coating. The carbon based coating is doped with nitrogen and the carbon based coating has an electrical resistivity lower than 10⁸ ohm-cm.

By applying a conductive, metal free coating comprising nitrogen the wettability of the substrate is increased as the surface is more hydrophilic. Consequently, the surface of the coated substrate can be cleaned more easily. As the surface is more hydrophilic deioinzed water can be used to clean the surface and the use of VOCs can be avoided.

Furthermore, the coating according to the present invention is metal free. This is important for applications whereby metal contamination is an issue.

A great advantage of the present invention is that the coating layer is at the same time conductive, metal free and hydrophilic.

The coating according to the present invention is in particular suitable for substrates whereby metal contamination is an issue.
Such substrates comprise for example components to transport and/or support a semiconductor substrate.
Examples of such components comprise electrostatics chucks, wafer carriers, heaters and lift pins.
Examples of semiconductor substrates include semiconductor wafers.

Components to transport and/or support a semiconductor substrate require a slightly conductive coating that avoids any possible contamination of the semiconductor substrate.

As the coating according to the present invention meets these requirements, the coating is of particular interest as coating for components to transport and/or support a semiconductor substrate.

The metal free conductive carbon based coating is applied at least on the surface or surfaces of the component that come in contact with the semiconductor substrate.
Possibly, the metal free conductive carbon based coating can be applied on other surfaces of the component as well.

In some embodiments the whole outer surface of the component is covered with a metal free conductive carbon based coating.
The coating is also suitable to coat components to transport and/or support high purity liquids used in semiconductor patterning and lithography.

Furthermore, the coating according to the present invention is suitable for substrates requiring a slightly conductive coating for charge dissipation. Examples of such substrates comprise copier components such as donor rolls, or for components used in Electrical Discharge Machining (EDM) applications.

The electrical resistivity of the carbon based coating is lower than 10⁸ ohm-cm, for example between 10³ ohm-cm and 10⁸ ohm-cm and more preferably between 10⁴ ohm-cm and 10⁶ ohm-cm.

The concentration of nitrogen is preferably between 0.1 and 20 at% and more preferably between 3 and 7 at%.

For most applications, it is preferred that the coating has a low coefficient of friction. For semiconductor applications a coating with a low coefficient of friction is preferred to reduce the formation and deposition of friction or abrasion resulting particles on the semiconductor substrate.
Preferably, the coefficient of friction of the coating is lower than 0.15 as for example between 0.05 and 0.10.
Furthermore, for most applications, it is preferred that the coating has a high hardness for example to avoid scratching and abrasion. Preferably, the hardness of the coating is higher than 10 GPa, for example higher than 12 GPa, 15 GPa , 18 GPa , 20 GPa or 25 GPa .

The carbon based coating has preferably a thickness ranging between 0.5 µm and 10 µm, and more preferably between 2.5 µm and 8 µm.

Carbon based layers comprise diamond-like carbon (DLC) coatings and diamond-like nanocomposite (DLN) coatings.

Diamond-like carbon (DLC) coatings comprise amorphous hydrogenated carbon (a-C:H). DLC coatings comprise a mixture of sp² and sp³ bonded carbon with a hydrogen concentration between 0 and 80 % and preferably between 20 and 30 %.

The hardness of a DLC layer is preferably between 15 GPa and 25 GPa. More preferably, the hardness of a DLC layer is between 18 GPa and 25 GPa.

Diamond like nanocomposite (DLN) coatings comprise an amorphous structure of C, H, Si and O. Diamond like nanocomposite coatings are commercially known as DYLYN^{®} coatings.

The hardness of a diamond layer nanocomposite layer is preferably between 10 GPa and 20 GPa.

Preferably, a DLN coating comprises in proportion to the sum of C, Si, and O : 40 to 90 at% C, 5 to 40 at% Si, and 5 to 25 at% O.

Preferably, the diamond-like nanocomposite composition comprises two interpenetrating networks of a-C:H and a-Si:O.

The carbon based coating can be deposited by any technique known in the art.

Preferred deposition techniques comprise ion beam deposition, pulsed laser deposition, arc deposition, such as filtered or non-filtered arc deposition, chemical vapor deposition, such as enhanced plasma assisted chemical vapor deposition and laser arc deposition.

According to the present invention, an adhesion promoting layer can be applied on the substrate before the application of the conductive, metal free, hydrophilic carbon based coating.

In principle any coating that is improving the adhesion of the carbon based coating to the substrate can be considered.

At least one adhesion promoting layer preferably comprises at least one element of the group consisting of silicon and the elements of group IVB, the elements of group VB, the elements of Group VIB of the periodic table. Preferred intermediate layers comprise Ti and/or Cr.

Possibly, the adhesion promoting layer comprises more than one layer, for example two or more metal layers, each layer comprising a metal selected from the group consisting of silicon, the elements of group IVB, the elements of group VB and the elements of group VIB of the periodic table, as for example a Ti or Cr layer.

Alternatively, the adhesion promoting layer comprises one or more layers of a carbide, a nitride, a carbonitride, an oxycarbide, an oxynitride, an oxycarbonitride of a metal selected from the group consisting of silicon, the elements of group IVB, the elements of group VB and the elements of group VIB of the periodic table.

Some examples are TiN, CrN, TiC, Cr₂C₃, TiCN and CrCN.

Furthermore, the adhesion promoting layer may comprise any combination of one or more metal layers of a metal selected from the group consisting of silicon, the elements of group IVB, the elements of group VB and the elements of group VIB of the periodic table and one or more layers of a carbide, a nitride, a carbonitride, an oxycarbide, an oxynitride, an oxycarbonitride of a metal selected from the group consisting of silicon, the elements of group IVB, the elements of group VB and the elements of group VIB of the periodic table.

Some examples of intermediate layers comprise the combination of a metal layer and a metal carbide layer, the combination of a metal layer and a metal nitride layer, the combination of a metal layer and a metal carbonitride layer, the combination of a first metal layer, a metal carbide layer and a second metal layer and the combination of a first metal layer, a metal nitride layer and a second metal layer.

The thickness of the adhesion promoting layer is preferably between 1 nm and 1000 nm, as for example between 10 and 500 nm.

The adhesion promoting layer can be deposited by any technique known in the art as for example physical vapor deposition, such as sputtering or evaporation.

According to a second aspect of the present invention a substrate according to claim 4 coated at least partially with a conductive, metal free, hydrophilic carbon based coating is provided. The carbon based coating is doped with nitrogen and has an electrical resistivity lower than 10⁸ ohm-cm.

Preferably, the electrical resistivity is between 10³ ohm-cm and 10⁸ ohm-cm and more preferably between 10⁴ ohm-cm and 10⁶ ohm-cm.

Substrates comprise components to transport and/or support a semiconductor substrate, such as electrostatic chucks, wafer carriers, heaters and lift pins; components to transport and/or support highly purity liquids; copier components and components used in Electrical Discharging Machining (EDM) applications.

According to a third aspect of the present invention a method according to claim 7 to allow the cleaning of a substrate such as a component to transport and/or support a semiconductor substrate with deionized water is provided.

The method comprises the steps of
- providing a substrate, said substrate being at least partially coated with a conductive, metal free, hydrophilic carbon based coating, said carbon based coating being doped with nitrogen and having an electrical resistivity lower than 10⁸ ohm-cm;
- cleaning said substrate with deionized water.

The cleaning may comprise rinsing and/or wiping and/or any other method of cleaning.

By applying a coating according to the present invention, the the wettability of the substrate is increased as the surface is more hydrophilic. Consequently, it is possible to clean the surface by using deioinzed water.

### Brief description of the drawings.

The invention will now be described into more detail with reference to the accompanying drawings wherein
- Figure 1 is a cross-sectional view of an electrostatic chuck according to the present invention;
- Figure 2 is a cross-sectional view of an assembly comprising a lift pin according to the present invention.

### Description of the preferred embodiments of the invention.

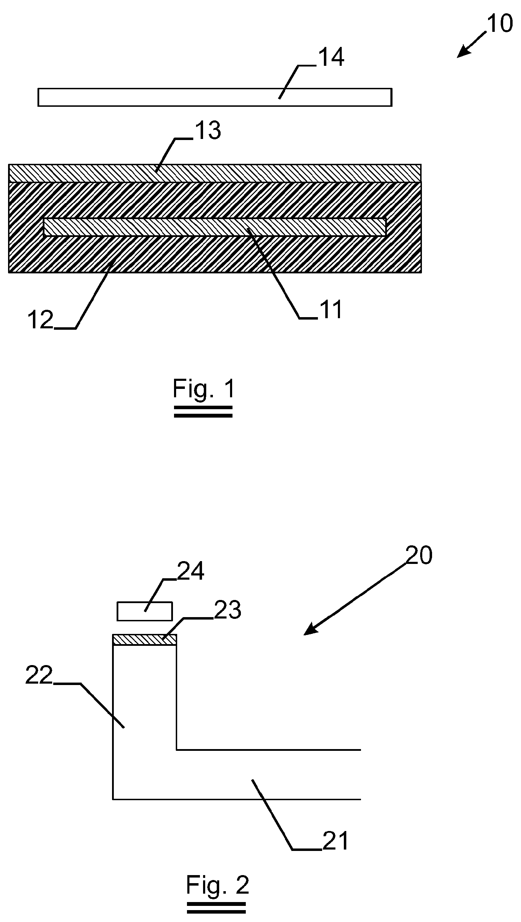

A preferred embodiment of an electrostatic chuck 10 according to the present invention is described with reference to Figure 1. Electrostatic chucks are widely used to retain substrates, such as semiconductor wafers or other workpieces, in a stationary position during processing.

Typically, electrostatic chucks contain one or more electrodes superimposed on or embedded in a dielectric material. As power is applied to the electrode, an attractive force is generated between the electrostatic chuck and the substrate disposed thereon.

It may be required to coat the electrostatic chuck with a coating layer having some conductivity so that the particle generation between the surface of the electrostatic chuck and the wafer is minimal.

The conductivity of the coating helps also to maintain the substrate at the desired process condition with minimal process deviation. However, any possible metal contamination should be avoided.

A preferred embodiment of an electrostatic chuck 10 according to the present invention is described with reference to Figure 1.

The electrostatic chuck 10 comprises
- at least one electrode 11;
- a dielectric body 12 at least partially covering the electrode 11;
- a metal free conductive carbon based coating 13 at least partially covering the dielectric body 12.

As power is applied to the electrode, an attractive force is generated between the electrostatic chuck and the substrate 14 disposed thereon.

The metal free conductive carbon based coating 13 according to the present invention has a thickness ranging from 1 to 10 µm and is preferably between 3 and 7 µm. The coating has an electrical resistivity ranging between 10³ ohm-cm and 10⁸ ohm-cm, and more preferably between 10⁴ ohm-cm and 10⁶ ohm-cm.

The coating comprises between 50 and 70 at% C, between 20 and 30 at% H and between 3 and 7 at% N. The coating 13 has a hardness in the range of 15 to 19 GPa.

The metal free conductive carbon based coating can be applied on the whole surface of the dielectric body 12 coming into contact with the substrate or can be applied on the dielectric body 12 in a pattern.

This pattern is preferably optimized to provide an optimal electrostatic chucking force and wafer supporting area with minimal particle generation.

Figure 2 shows a lift pin 20 according to the present invention.

The lift pin 20 comprises a member 21 having a tip 22 adapted to lift and lower a substrate 24.

The lift pin 20 is coated at least at the tip 22 with a metal free conductive carbon based coating 23.

The metal free conductive carbon based coating 24 according to the present invention has a thickness ranging between 1 and 10 µm and preferably ranging between 2 and 4 µm. The coating has an electrical resistivity ranging from 10³ ohm-cm to 10⁸ ohm-cm and more preferably between 10⁴ ohm-cm and 10⁶ ohm-cm.

The coating comprises between 50 and 70 at% C, between 20 and 30 at% H and between 3 and 7 at% N. The coating 23 has a hardness in the range of 15 to 19 GPa.

## Claims

1. A method to increase the wettability of a substrate (10, 20), which substrate (10, 20) is selected from the group consisting of components to transport and/or support a semiconductor substrate, such as electrostatic chucks, wafer carriers, heaters and lift pins and components to transport and/or support highly purity liquids, copier components and components used in Electrical Discharge Machining (EDM) applications,
by providing said substrate (10, 20) at least partially with a conductive, metal free, hydrophilic carbon based coating (13), said carbon based coating (13) being doped with nitrogen, said carbon based coating (13) having an electrical resistivity lower than 10⁸ ohm-cm,
and an adhesion promoting layer is applied on said substrate (10, 20) before the application of said carbon based coating (13), wherein the adhesion promoting layer comprises at least one layer, said adhesion promoting layer comprising at least one element of the group consisting of silicon and of the elements of group IVB, the elements of group VB and the elements of Group VIB of the periodic table,
**characterized in that**
the carbon based coating (13) comprises a nitrogen doped diamond-like carbon (DLC) coating comprising amorphous hydrogenated carbon (a-C:H) and said carbon based coating (13) comprises a nitrogen doped diamond-like nanocomposite (DLN) coating comprising C, H, O and Si.

2. A method according to claim 1, whereby said carbon based coating (13) comprises between 0.1 and 20 at% nitrogen.

3. A method according to claim 1 or 2, whereby said diamond-like nanocomposite coating comprises two interpenetrating networks, a first network of predominantly sp³ bonded carbon in a diamond-like carbon network stabilized by hydrogen and a second network of silicon stabilized oxygen.

4. A substrate (10, 20) selected from the group consisting of components to transport and/or support a semiconductor substrate, such as electrostatic chucks, wafer carriers, heaters and lift pins and components to transport and/or support highly purity liquids, copier components and components used in Electrical Discharge Machining (EDM) applications
being coated at least partially with a conductive, metal free, hydrophilic carbon based coating (13), said metal free conductive carbon based coating (13) being doped with nitrogen, said carbon based coating (13) having an electrical resistivity lower than 10⁸ ohm-cm,
and an adhesion promoting layer is applied on said substrate (10, 20) before the application of said carbon based coating (13), wherein the adhesion promoting layer comprises at least one layer, said adhesion promoting layer comprising at least one element of the group consisting of silicon and of the elements of group IVB, the elements of group VB and the elements of Group VIB of the periodic table,
**characterized in that**
the carbon based coating (13) comprises a nitrogen doped diamond-like carbon (DLC) coating comprising amorphous hydrogenated carbon (a-C:H) and said carbon based coating (13) comprises a nitrogen doped diamond-like nanocomposite (DLN) coating comprising C, H, O and Si.

5. A substrate according to claim 4, whereby said carbon based coating (13) comprises between 0.1 and 20 at% nitrogen.

6. A substrate according to claim 4 or 5, whereby said diamond-like nanocomposite coating comprises two interpenetrating networks, a first network of predominantly sp³ bonded carbon in a diamond-like carbon network stabilized by hydrogen and a second network of silicon stabilized oxygen.

7. A method to allow cleaning of a substrate (10, 20) with deionized water; which substrate (10, 20) is selected from the group consisting of components to transport and/or support a semiconductor substrate, such as electrostatic chucks, wafer carriers, heaters and lift pins and components to transport and/or support highly purity liquids, copier components and components used in Electrical Discharge Machining (EDM) applications, said method comprising the steps of
- providing a substrate (10, 20), said substrate (10, 20) being at least partially coated with a conductive, metal free, hydrophilic carbon based coating (13), said carbon based coating (13) being doped with nitrogen and having an electrical resistivity lower than 10⁸ ohm-cm;
- cleaning said substrate (10, 20) with deionized water, and an adhesion promoting layer is applied on said substrate (10, 20) before the application of said carbon based coating (13), wherein the adhesion promoting layer comprises at least one layer, said adhesion promoting layer comprising at least one element of the group consisting of silicon and of the elements of group IVB, the elements of group VB and the elements of Group VIB of the periodic table,
**characterized in that**
the carbon based coating (13) comprises a nitrogen doped diamond-like carbon (DLC) coating comprising amorphous hydrogenated carbon (a-C:H) and said carbon based coating (13) comprises a nitrogen doped diamond-like nanocomposite (DLN) coating comprising C, H, O and Si.

## Patentansprüche

1. Verfahren zum Erhöhen der Benetzbarkeit eines Substrats (10, 20), welches Substrat (10, 20) aus der Gruppe ausgewählt wird, die aus Komponenten, um ein Halbleitersubstrat zu transportieren und/oder abzustützen, wie etwa elektrostatische Aufnahmen, Wafer-Träger, Heizungen und Hubstifte, und Komponenten, um hochreine Flüssigkeiten zu transportieren und/oder abzustützen, Kopiererkomponenten und Komponenten, die in Electrical Discharge Machining (EDM) Anwendungen verwendet werden, besteht,
indem das Substrat (10, 20) zumindest teilweise mit einer leitenden, metallfreien, hydrophilen Beschichtung (13) auf Kohlenstoffbasis versehen wird, wobei die Beschichtung (13) auf Kohlenstoffbasis mit Stickstoff dotiert wird, wobei die Beschichtung (13) auf Kohlenstoffbasis einen spezifischen elektrischen Widerstand niedriger als 10⁸ Ohm-cm aufweist,
und vor der Aufbringung der Beschichtung (13) auf Kohlenstoffbasis eine die Anhaftung fördernde Schicht auf das Substrat (10, 20) aufgebracht wird, wobei die die Anhaftung fördernde Schicht zumindest eine Schicht umfasst, wobei die die Anhaftung fördernde Schicht zumindest ein Element aus der Gruppe bestehend aus Silizium und aus den Elementen der Gruppe IVB, den Elementen der Gruppe VB und den Elementen der Gruppe VIB des Periodensystems umfasst,
**dadurch gekennzeichnet, dass**
die Beschichtung (13) auf Kohlenstoffbasis eine mit Stickstoff dotierte, diamantartige Kohlenstoffbeschichtung (DLC-Beschichtung) umfasst, die amorphen, hydrierten Kohlenstoff (a-C:H) umfasst, und die Beschichtung (13) auf Kohlenstoffbasis eine mit Stickstoff dotierte, diamantartige Nanokompositbeschichtung (DLN-Beschichtung) umfasst, die C, H, O und Si umfasst.

2. Verfahren nach Anspruch 1, wobei die Beschichtung (13) auf Kohlenstoffbasis zwischen 0,1 und 20 At-% Stickstoff umfasst.

3. Verfahren nach Anspruch 1 oder 2, wobei die diamantartige Nanokompositbeschichtung zwei einander durchdringende Netze umfasst, und zwar ein erstes Netz aus vorwiegend sp³-gebundenem Kohlenstoff in einem diamantartigen Kohlenstoffnetz, das mit Wasserstoff stabilisiert ist, und ein zweites Netz aus mit Silizium stabilisiertem Sauerstoff.

4. Substrat (10, 20), das aus der Gruppe ausgewählt ist, die aus Komponenten, um ein Halbleitersubstrat zu transportieren und/oder abzustützen, wie etwa elektrostatische Aufnahmen, Wafer-Träger, Heizungen und Hubstifte, und Komponenten, um hochreine Flüssigkeiten zu transportieren und/oder abzustützen, Kopiererkomponenten und Komponenten, die in Electrical Discharge Machining (EDM) Anwendungen verwendet werden, besteht, welches zumindest teilweise mit einer leitenden, metallfreien, hydrophilen Beschichtung (13) auf Kohlenstoffbasis beschichtet ist, wobei die metallfreie, leitende Beschichtung (13) auf Kohlenstoffbasis mit Stickstoff dotiert ist, wobei die Beschichtung (13) auf Kohlenstoffbasis einen spezifischen elektrischen Widerstand niedriger als 10⁸ Ohm-cm aufweist,
und vor der Aufbringung der Beschichtung (13) auf Kohlenstoffbasis eine die Anhaftung fördernde Schicht auf das Substrat (10, 20) aufgebracht ist, wobei die die Anhaftung fördernde Schicht zumindest eine Schicht umfasst, wobei die die Anhaftung fördernde Schicht zumindest ein Element aus der Gruppe bestehend aus Silizium und aus den Elementen der Gruppe IVB, den Elementen der Gruppe VB und den Elementen der Gruppe VIB des Periodensystems umfasst,
**dadurch gekennzeichnet, dass**
die Beschichtung (13) auf Kohlenstoffbasis eine mit Stickstoff dotierte, diamantartige Kohlenstoffbeschichtung (DLC-Beschichtung) umfasst, die amorphen, hydrierten Kohlenstoff (a-C:H) umfasst, und die Beschichtung (13) auf Kohlenstoffbasis eine mit Stickstoff dotierte, diamantartige Nanokompositbeschichtung (DLN-Beschichtung) umfasst, die C, H, O und Si umfasst.

5. Substrat nach Anspruch 4, wobei die Beschichtung (13) auf Kohlenstoffbasis zwischen 0,1 und 20 At-% Stickstoff umfasst.

6. Substrat nach Anspruch 4 oder 5, wobei die diamantartige Nanokompositbeschichtung zwei einander durchdringende Netze umfasst, und zwar ein erstes Netz aus vorwiegend sp³-gebundenem Kohlenstoff in einem diamantartigen Kohlenstoffnetz, das mit Wasserstoff stabilisiert ist, und ein zweites Netz aus mit Silizium stabilisiertem Sauerstoff.

7. Verfahren, um die Reinigung eines Substrats (10, 20) mit deionisiertem Wasser zuzulassen; welches Substrat (10, 20) aus der Gruppe ausgewählt ist, die aus Komponenten, um ein Halbleitersubstrat zu transportieren und/oder abzustützen, wie etwa elektrostatische Aufnahmen, Wafer-Träger, Heizungen und Hubstifte, und Komponenten, um hochreine Flüssigkeiten zu transportieren und/oder abzustützen, Kopiererkomponenten und Komponenten, die in Electrical Discharge Machining (EDM) Anwendungen verwendet werden, besteht, wobei das Verfahren die Schritte umfasst, dass
- ein Substrat (10, 20) vorgesehen wird, wobei das Substrat (10, 20) zumindest teilweise mit einer leitenden, metallfreien, hydrophilen Beschichtung (13) auf Kohlenstoffbasis beschichtet wird, wobei die Beschichtung (13) auf Kohlenstoffbasis mit Stickstoff dotiert wird und einen spezifischen elektrischen Widerstand niedriger als 10⁸ Ohm-cm aufweist;
- das Substrat (10, 20) mit deionisiertem Wasser gereinigt wird,
und vor der Aufbringung der Beschichtung (13) auf Kohlenstoffbasis eine
die Anhaftung fördernde Schicht auf das Substrat (10, 20) aufgebracht wird, wobei die die Anhaftung fördernde Schicht zumindest eine Schicht umfasst, wobei die die Anhaftung fördernde Schicht zumindest ein Element aus der Gruppe bestehend aus Silizium und aus den Elementen der Gruppe IVB, den Elementen der Gruppe VB und den Elementen der Gruppe VIB des Periodensystems umfasst,
**dadurch gekennzeichnet, dass**
die Beschichtung (13) auf Kohlenstoffbasis eine mit Stickstoff dotierte, diamantartige Kohlenstoffbeschichtung (DLC-Beschichtung) umfasst, die amorphen, hydrierten Kohlenstoff (a-C:H) umfasst, und die Beschichtung (13) auf Kohlenstoffbasis eine mit Stickstoff dotierte, diamantartige Nanokompositbeschichtung (DLN-Beschichtung) umfasst, die C, H, O und Si umfasst.

## Revendications

1. Méthode pour augmenter la mouillabilité d'un substrat (10, 20), lequel substrat (10, 20) est sélectionné parmi le groupe constitué de composants pour transporter et/ou supporter un substrat semi-conducteur, tels qu'un mandrin électrostatique, des supports de plaquette, des dispositifs de chauffage et des broches de soulèvement et de composants pour transporter et/ou supporter des liquides à haute pureté, des composants de copiage et des composants utilisés dans des applications d'usinage à décharge électrique (EDM), en munissant le substrat (10, 20) au moins partiellement d'un revêtement conducteur, sans métal à base de carbone hydrophile (13), le revêtement à base de carbone (13) étant dopé avec de l'azote, le revêtement à base de carbone (13) ayant une résistivité électrique plus faible que 10⁸ ohms-cm,
et une couche favorisant l'adhérence est appliquée sur le substrat (10, 20) avant l'application du revêtement à base de carbone (13), dans laquelle la couche favorisant l'adhérence comprend au moins une couche, la couche favorisant l'adhérence comprenant au moins un élément du groupe constitué de silicium et des éléments du groupe IVB, des éléments du groupe VB et des éléments du groupe VB de la table périodique,
**caractérisée en ce que** le revêtement à base de carbone (13) comprend un revêtement de carbone du type diamant (DLC) dopé à l'azote comprenant du carbone hydrogéné amorphe (a-C:H) et le revêtement à base de carbone (13) comprend un revêtement nano-composite du type diamant dopé à l'azote (DLN) comprenant C, H, 0 et Si.

2. Méthode selon la revendication un, par laquelle le revêtement à base de carbone (13) comprend entre 0,1 et 20 atm% d'azote.

3. Méthode selon les revendications 1 ou 2, par laquelle le revêtement nano-composite du type diamant comprend deux réseaux interpénétrés, un premier réseau de carbone lié de manière prédominante à sp3 dans un réseau de carbone du type diamant stabilisé par de l'hydrogène et un second réseau d'oxygène stabilisé au silicium.

4. Substrat (10, 20) sélectionné parmi le groupe constitué de composants pour transporter et/ou supporter un substrat semi-conducteur, tels que des mandrins électrostatiques, des supports de plaquette, des dispositifs de chauffage et des broches de soulèvement et de composants pour transporter et/ou supporter des liquides à haute pureté, des composants de copiage et des composants utilisés dans des applications d'usinage à décharge électrique (EDM), en munissant le substrat (10, 20) au moins partiellement d'un revêtement hydrophile, conducteur, sans métal, à base de carbone (13), le revêtement à base de carbone (13) étant dopé avec de l'azote, le revêtement à base de carbone (13) ayant une résistivité électrique plus faible que 10⁸ ohm-cm,
et une couche favorisant l'adhérence est appliquée sur le substrat (10, 20) avant l'application du revêtement à base de carbone (13), dans laquelle la couche favorisant l'adhérence comprend au moins une couche, la couche favorisant l'adhérence comprenant au moins un élément du groupe constitué de silicium et des éléments du groupe IVB, des éléments du groupe VB et des éléments du groupe VB de la table périodique,
**caractérisée en ce que** le revêtement à base de carbone (13) comprend un revêtement de carbone du type diamant (DLC) dopé à l'azote comprenant du carbone hydrogéné amorphe (a-C:H) et le revêtement à base de carbone (13) comprend un revêtement nano-composite du type diamant dopé à l'azote (DLN) comprenant C, H, 0 et Si.

5. Substrat selon la revendication 4, par lequel le revêtement à base de carbone (13) comprend entre 0,1 et 20 atm% d'azote.

6. Substrat selon la revendication 4 ou 5, par lequel le revêtement nano-composite du type diamant comprend deux réseaux interpénétrés, un premier réseau de carbone lié de manière prédominante à sp3 dans un réseau de carbone du type diamant stabilisé par l'hydrogène et un second réseau d'oxygène stabilisé au silicium.

7. Procédé pour permettre de nettoyer un substrat (10, 20) avec de l'eau désionisée, lequel substrat est sélectionné parmi le groupe constitué de composants pour transporter et/ou supporter un substrat semi-conducteur, tels que des mandrins électrostatiques, des supports de plaquette, des dispositifs de chauffage et des broches de soulèvement et de composants pour transporter et/ou supporter des liquides à haute pureté, des composants de copiage et des composants utilisés dans des applications d'usinage à décharge électrique (EDM), en munissant le substrat (10, 20) au moins partiellement d'un revêtement hydrophile, conducteur, sans métal, à base de carbone (13), le revêtement à base de carbone (13) étant dopé avec de l'azote, le revêtement à base de carbone (13) ayant une résistivité électrique plus faible que 10⁸ ohms-cm,
et une couche favorisant l'adhérence est appliquée sur le substrat (10, 20) avant l'application du revêtement à base de carbone (13), dans laquelle la couche favorisant l'adhérence comprend au moins une couche, la couche favorisant l'adhérence comprenant au moins un élément du groupe constitué de silicium et des éléments du groupe IVB, des éléments du groupe VB et des éléments du groupe VB de la table périodique,
**caractérisée en ce que** le revêtement à base de carbone (13) comprend un revêtement de carbone du type diamant (DLC) dopé à l'azote comprenant du carbone hydrogéné amorphe(a-C:H) et le revêtement à base de carbone (13) comprend un revêtement nano-composite du type diamant dopé à l'azote (DLN) comprenant C, H, 0 et Si.
